# EUROPEAN PATENT APPLICATION

(11) **EP 2 662 425 A2**
(43) Date of publication of application: **13.11.2013**
(21) Application number: 13159025.9
(22) Date of filing: 13.03.2013
(51) Int. Cl.: C09D 163/00, C08L 63/00, C08J 5/24, H05K 1/03

(54) **Epoxy Resin Composition, and Prepreg and Copper Clad Laminate Made Therefrom**

(30) Priority: 05.04.2012 CN 201210101885
(71) Applicant: Shengyi Technology Co., Ltd., 523000 Dongguan City Guangdong (CN)
(72) Inventor: Zeng, Xianping, 523000 Dongguan City (CN); Tang, Junqi, 523000 Dongguan City (CN)
(74) Representative: Stuttard, Garry Philip

(57) **Abstract**

The present invention relates to an epoxy resin composition, and a prepreg and a copper clad laminate made therefrom. The epoxy resin composition comprises the following essential components: (A) at least an epoxy resin, of which the melt viscosity is not more than 0.5 Pa.s under the temperature of 150 °C; (B) phenolic resin, of which the structure is as shown in the formula 1: 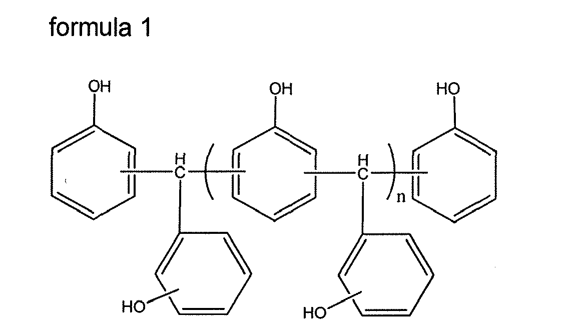 wherein, n represents an integer of 0-10. The epoxy resin composition of the present invention can provide the prepreg and copper clad laminate made therefrom with high glass transition temperature, high heat resistance, low expansion coefficient and low moisture absorption, which can meet demands of high reliability of high density multi-layer PCBs.

## Description

### FIELD OF THE INVENTION

The present invention relates to an epoxy resin composition, particularly relates to an epoxy resin composition, and a prepreg and a copper clad laminate made therefrom.

### BACKGROUND OF THE INVENTION

Recently, with the technique of lead-free being implemented completely, higher requirements on heat resistance of copper clad laminate are raised. Meanwhile, conventional copper clad laminate materials adopting dicyandiamide as curing agent for epoxy resins are unable to meet demands of heat resistance and reliability under the lead-free circumstance. In order to solve this technique problem in this field, dicyandiamide is generally substituted by phenolic resin as curing agent for epoxy resin, and inorganic fillers is added to the epoxy resin composition, so as to improve heat resistance of the cured products and reduce the expansion coefficient thereof, thereby providing better reliability in using PCBs. Traditional brominated bisphenol A type epoxy resins used to be used are also replaced by novolac epoxy resins that have more excellent heat resistance, such as phenol novolac type epoxy resin, cresol novolac epoxy resin, bisphenol A type novolac epoxy resin, dicyclopentadiene phenol epoxy resin, so as to effectively improve heat resistance of the cured products. But, the use of ordinary novolac epoxy resin and phenolic resin causes increase of fragileness and decrease of drilling processability for the cured products, which will easily lead to the phenomenon of delamination in the lead-free process.

In addition, the addition of filler can effectively reduce the thermal expansion coefficient of the cured products, but flowability and via filling property during producing PCBs are impaired, so drawbacks such as decrease of reliability, cracking of fiberglass cloth under lead-free process emerge.

### SUMMARY OF THE INVENTION

An object of the present invention is to provide an epoxy resin composition, which has good flowability, and after being cured has high glass transition temperature, high heat resistance, low expansion coefficient and low moisture absorption.

Another object of the present invention is to provide a prepreg and a copper clad laminate made from the above mentioned epoxy resin composition, which has high glass transition temperature, high heat resistance, low expansion coefficient and low moisture absorption and is able to meet demands of high reliability of high density multi-layer PCBs.

To achieve the above objects, the present invention provides an epoxy resin composition, which comprises the following essential components:

(A) at least an epoxy resin, of which the melt viscosity is not more than 0.5 Pa.s under the temperature of 150 °C;

(B) phenolic resin, of which the structure formula is as shown in the formula 1:

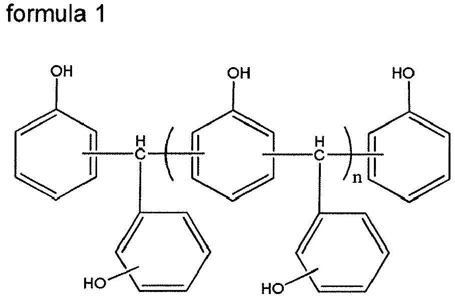

wherein, n represents an integer of 0-10.

The epoxy resin of the component (A) is mutifunctional epoxy resin with the functionality thereof being not less than 2 and epoxy equivalent weight (EEW) thereof being not more than 300 g/eq.

The epoxy resin comprises cresol novolac epoxy resin, bisphenol A type novolac epoxy resin, dicyclopentadiene phenol epoxy resin, biphenyl type epoxy resin, naphthol type epoxy resin, alkylated benzene epoxy resins, tri-functional epoxy resin and tetra-functional epoxy resin, and the component (A) is at least one of the above mentioned epoxy resins; the structure formula of the tri-functional epoxy resin is as shown in the formula 2: 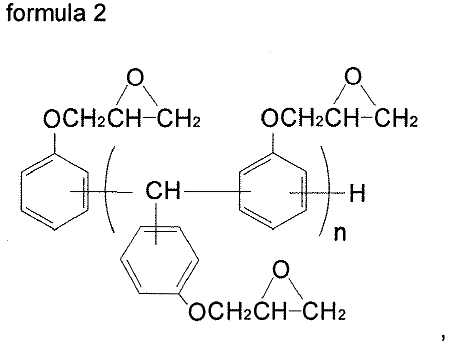 n represents an integer of 1-10.

The epoxy resin composition also comprises flame retardant, and the flame retardant is bromine-containing flame retardant or halogen-free flame retardant; the bromine-containing flame retardant is non-reactive or reactive bromine-containing flame retardant; the reactive bromine-containing flame retardant is brominated epoxy resin, which is one or more selected from brominated bisphenol A type epoxy resin, brominated novolac type epoxy resin and brominated isocyanate modified epoxy resin; the non-reactive bromine-containing flame retardant is one or more selected from decabromodiphenyl ether, decabromobibenzyl, brominated styrene, ethylenebistetrabromophthalimide, and brominated polycarbonate.

The bromine content of the brominated epoxy resin is 15-55%; taking the total amount of the component (A) and component (B) in the epoxy resin composition as 100 parts by weight, the usage amount of the brominated epoxy resin is 10-50 parts by weight.

The epoxy resin composition also comprises inorganic filler or organic filler, of which the particle diameter is 0.1-10 µm; the inorganic filler is irregular or spherical inorganic filler, which is one or more selected from the group consisting of crystalline silica, fused silica, spherical silica, hollow silica, glass powder, aluminum nitride, boron nitride, silicon carbide, aluminum hydroxide, titanium dioxide, strontium titanate, barium titanate, alumina, barium sulfate, talcum powder, calcium silicate, calcium carbonate, and mica; the organic filler is one or more selected from polytetrafluoroethylene powder, polyphenylene sulfide powder, and poly(ether sulfones) powder.

The inorganic filler is spherical inorganic fillers after a surface treatment with surface treating agent; the surface treating agent is silane coupling agent, which is one or more selected from epoxy silane coupling agent, amino silane coupling agent and sulfur silane coupling agent.

The epoxy resin composition further comprises curing accelerator, which is one or more selected from imidazole compounds, derivatives of imidazole compounds, piperidine compounds, and triphenylphosphine.

The present invention also provides a prepreg made from the above mentioned epoxy resin composition, which comprises a reinforcing material, and the epoxy resin composition that adheres to the reinforcing material after the reinforcing material is dipped in the epoxy resin composition and then is dried.

Furthermore, the present invention also provides a copper clad laminate made from the above mentioned epoxy resin composition, which comprises: a plurality of laminated prepregs and copper foil cladded to one side or two sides of the laminated prepregs; each prepreg comprises a reinforcing material, and the epoxy resin composition that adheres to the reinforcing material after the reinforcing material is dipped in the epoxy resin composition and then is dried.

The advantages of the present invention: (1) the epoxy resin composition of the present invention adopts the epoxy resin with the melt viscosity thereof is not more than 0.5 Pa.s under the temperature of 150 °C , which has compatatively low melt viscosity, thereby the epoxy resin composition having good flowability; (2) the epoxy resin composition of the present invention adopts the phenolic resin as shown in the structure formula 1 as the curing agent, to make the resin composition have high glass transition temperature after being cured, and the curing agent after being cured can form three-dimensional crosslinked network, so as to meet requirements of high reliability of high density multi-layer PCBs.

### DESCRIPTION OF THE PREFERRED EMBODIMENT

The epoxy resin composition of the present invention comprises the following essential components:

(A) at least an epoxy resin, of which the melt viscosity is not more than 0.5 Pa.s under the temperature of 150 °C;

(B) phenolic resin, of which the structure is as shown in the formula 1:

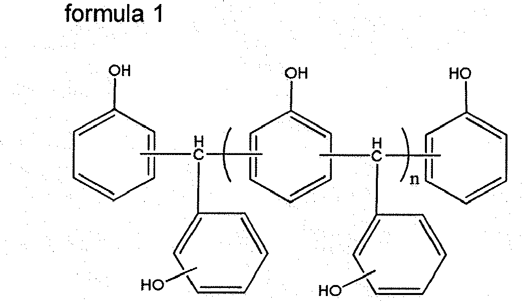

wherein, n represents an integer of 0-10.

The epoxy resin of the component (A) is mutifunctional epoxy resin with the functionality thereof being not less than 2 and epoxy equivalent weight (EEW) thereof being not more than 300 g/eq. The epoxy resin that can be selected as the component (A) the comprises cresol novolac epoxy resin, bisphenol A type novolac epoxy resin, dicyclopentadiene phenol epoxy resin, biphenyl type epoxy resin, naphthol type epoxy resin, alkylated benzene epoxy resins, tri-functional epoxy resin and tetra-functional epoxy resin, and the component (A) can be at least one of the above mentioned epoxy resins.

Wherein, the structure formula of the tri-functional epoxy resin is as shown in the following formula 2: 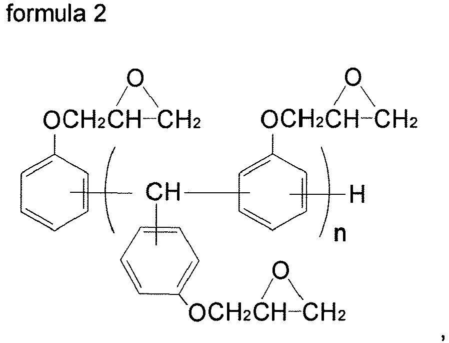 n represents an integer of 1-10;

The structure formula of dicyclopentadiene phenol epoxy resin is as shown in the following formula 3: 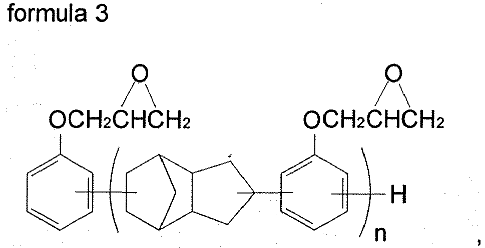 n represents an integer of 1-8.

The component (B) phenolic resin in the epoxy resin composition of the present invention, of which the functionality of phenolic group is not less than 3, is used as a curing agent in the epoxy resin composition, to carry out curing and cross-linking the epoxy resin. After curing and cross-linking is finished, the cured products have high glass transition temperature and low expansion coefficient. The usage amount of the component (B) phenolic resin is calculated according to the ratio of epoxy equivalent weight to hydroxyl equivalent weight of the epoxy resin, and the ratio is 0.9-1.2, preferred to be 0.95-1.1, and more preferred to be 0.98-1.05.

Besides the component (A) epoxy resin, the epoxy resin composition of the present invention can also comprise other types of epoxy resins. For example, in order to meet needs of flame retardance of the cured products, flame retardant can be added, which can be bromine-containing flame retardant or halogen-free flame retardant; the bromine-containing flame retardant is non-reactive or reactive bromine-containing flame retardant. The reactive bromine-containing flame retardant can be brominated epoxy resin, which is one or more selected from brominated bisphenol A type epoxy resin, brominated novolac type epoxy resin and brominated isocyanate modified epoxy resin; the bromine content of the brominated epoxy resin is 15-55%. The non-reactive brominated flame retardant can be one or more selected from decabromodiphenyl ether, decabromobibenzyl, brominated styrene, ethylenebistetrabromophthalimide, and brominated polycarbonate.

The usage amount of the above mentioned flame retardants is not particularly limited as long as flame retardance level of the cured products achieves level UL 94 V-0. If a bromine-containing flame retardant is adopted, the usage amount thereof can be calculated according to the bromine content of different bromine-containing flame retardants, and taking the total amount of the component (A) and component (B) as 100 parts by weight, the bromine content is 10-20%. When the bromine content is less than 10%, the flame retardance can not reach level V-0; when the bromine content is more than 20%, it makes sure that the flame retardance level of the cured products reaches level V-0, but due to the increase of bromine content, heat resistance of the cured products sharply drops. When the flame retardant is brominated epoxy resin, taking the total amount of the component (A) and component (B) in the epoxy resin composition as 100 parts by weight, the usage amount of the brominated epoxy resin is 10-50 parts by weight.

In order to further reduce the thermal expansion coefficient of the cured products, the epoxy resin composition of the present invention also comprises filler. The filler is inorganic filler or organic filler, of which the average particle diameter is 0.1-10 µm. The inorganic filler is irregular or spherical inorganic filler, which can be one or more selected from the group consisting of crystalline silica, fused silica, spherical silica, hollow silica, glass powder, aluminum nitride, boron nitride, silicon carbide, aluminum hydroxide, titanium dioxide, strontium titanate, barium titanate, alumina, barium sulfate, talcum powder, calcium silicate, calcium carbonate, and mica; the organic filler is one or more selected from polytetrafluoroethylene powder, polyphenylene sulfide, and poly(ether sulfones) powder. The inorganic filler is preferred to be spherical inorganic fillers after a surface treatment; the surface treating agent adopted can be silane coupling agent, which is preferred to be one or a mixture of more selected from epoxy silane coupling agent, amino silane coupling agent, phenylamino group silane coupling agent and sulfur silane coupling agent. Taking the total amount of the component (A) and component (B) as 100 parts by weight, the usage amount of the filler is 5-500 parts by weight, and preferred to be 5-300 parts by weight.

Besides, the epoxy resin composition of the present invention can further comprise curing accelerator, which can be one or more selected from imidazole compounds, derivatives of imidazole compounds, piperidine compounds, and triphenylphosphine. The imidazole compounds can be such as 2-methylimidazole, 2-ethyl-4-methylimidazole, and 2-phenylimidazole. The usage amount of the curing accelerator in the present invention is not particularly restrictive, according to the process requirements, taking the total amount of the component (A) and component (B) as 100 parts by weight, which can be 0.01-1.0 parts by weight, and be preferred to be 0.04-0.5 parts by weight.

The prepreg made from the above mentioned epoxy resin composition comprises a reinforcing material, and the epoxy resin composition that adheres to the reinforcing material after the reinforcing material is dipped in the epoxy resin composition and then is dried. The reinforcing material can use reinforcing materials of existing technology, such as fiberglass cloth. The copper clad laminate made from the above mentioned epoxy resin composition, which comprises a plurality of laminated prepregs and copper foil cladded to one side or two sides of the laminated prepregs, and the prepregs are made from the epoxy resin composition.

In the process of making prepregs, prepare the epoxy resin composition of the present invention into a solution with a certain concentration, dip the reinforcing material in the solution, and then dry the reinforcing material under a certain temperature to remove the solvent and semi-cure the epoxy resin composition, thereby obtaining the prepreg. Then, overlay one or more of the above mentioned prepregs with each other in a certain sequence, respectively clad copper foils to the two sides of the prepregs overlaid with each other, and then cure the prepregs in hot press at a curing temperature of 150-250 °C and a curing pressure of 25-60 Kg/cm2, thereby obtaining a copper clad laminate.

By measuring properties, such as glass transition temperature, and resistance to humidity and heat, of the above mentioned produced copper clad laminate, the present invention is further detailedly described with the following embodiments.

Embodiment 1:

Set a vessel, add 53 parts by weight of phenol type novolac epoxy resin PN177 (pruduced by Taiwan Chang Chun Plastics Co., Ltd.), 20 parts by weight of brominated bisphenol A type epoxy resin DER530 (bromine content: 18%-20%, produced by Dow Chemical Company) and 27 parts by weight of high-bromide epoxy resin BEB400 (bromine content: 46%-50%, pruduced by Taiwan Chang Chun Plastics Co., Ltd.) to the vessel, then add 28 parts by weight of novolac curing agent MEH-7500 (hydroxyl equivalent weight: 96 g/mol, proudecd by Japanese MEIWA PLASTIC INDUSTRIES, LTD.), add butanone as a solvent, stir for some time to obtain a transparent glue solution, then add appropriate amount of 2-methylimidazole, and continue to stir evenly, thereby obtaining a glue solution. Dip fiberglass cloth (type being 7628, thickness being 0.16mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press, thereby obtaining the copper clad laminate. The physical property data are as shown in Table 1.

Embodiments 2-9:

The process of the embodiments 2-9 is similar to the embodiment 1, and, the formula and the physical property data thereof are as shown in Table 1 and Table 2.

Comparison examples 1-3:

The process of the comparison examples 1-3 is similar to the embodiment 1, and, the formula and the physical property data thereof are as shown in Table 2.

Table 1 Formula of the embodiments 1-6 and the physical property data thereof

| Component name | Embodiment 1 | Embodiment 2 | Embodiment 3 | Embodiment 4 | Embodiment 5 | Embodiment 6 |
|---|---|---|---|---|---|---|
| N740 | 53 | --- | --- | --- | --- | --- |
| N670 | --- | 28 | --- | --- | --- | --- |
| N865 | --- | --- | 34 | --- | --- | --- |
| HP-7200H | --- | --- | --- | 35 | --- | 50 |
| EPPN-501 | --- | 22 | 36 | 35 | 50 | --- |
| BEB400 | 20 | 20 | 30 | 30 | --- | --- |
| DER530 | 27 | --- | --- | --- | --- | --- |
| BREN-S | --- | --- | --- | --- | 50 | 50 |
| MEH7500 (equivalence ratio relative to epoxy resin) | 1 eq | 0.97 eq | 1.05 eq | 1.1 eq | 0.94 eq | 1 eq |
| 2E4MZ | 0.075 | 0.075 | 0.075 | 0.075 | 0.075 | 0.075 |
| butanone | appropriate amount | appropriate amount | appropriate amount | appropriate amount | appropriate amount | appropriate amount |
| Tg(DMA)/°C | 180 | 190 | 210 | 215 | 230 | 195 |
| via filling property | good | good | good | good | good | good |
| heat resistance | 250 | 260 | 260 | 265 | 280 | 265 |
| hydroscopic property, % | 0.12 | 0.13 | 0.13 | 0.13 | 0.16 | 0.14 |
| resistance to humidity and heat | 3/3 | 3/3 | 3/3 | 3/3 | 3/3 | 3/3 |

Table 2 Formula of the embodiments 7-9 and the comparison examples 1-3, and the physical property data thereof

| Component name | Embodiment 7 | Embodiment 8 | Embodiment 9 | Comparison example 1 | Comparison example 2 | Comparison example 3 |
|---|---|---|---|---|---|---|
| HP-7200HH | --- | --- | --- | 60 | --- | 55 |
| EPPN-501 | 50 | 55 | 50 | --- | 50 | --- |
| BEB400 | --- | --- | --- | --- | 50 | 45 |
| BREN-S | 50 | --- | 30 | 40 | --- | --- |
| DER593 | --- | --- | 20 | --- | --- | |
| SO-C2 | 40 | 35 | 60 | 40 | 100 | 40 |
| BT-93W | --- | 25 | --- | --- | | |
| MEH7500 (equivalence ratio relative to | 1.0 | 1.0 | 1.0 | 1.0 | | |
| epoxy resin) | | | | | | |
| TD-2090 (equivalence ratio relative to epoxy resin) | --- | --- | --- | --- | 1.0 | 1.0 |
| 2E4MZ | 0.075 | 0.075 | 0.075 | 0.075 | 0.075 | 0.075 |
| butanone | appropriate amount | appropriate amount | appropriate amount | appropriate amount | appropriate amount | appropriate amount |
| Tg(DMA)/°C | 195 | 190 | 210 | 215 | 175 | 165 |
| via filling property | good | good | good | poor | less good | good |
| heat resistance | 260 | 270 | 260 | 265 | 260 | 250 |
| hydroscopic property, % | 0.09 | 0.095 | 0.075 | 0.10 | 0.011 | 0.14 |
| resistance to humidity and heat | 3/3 | 3/3 | 3/3 | 3/3 | 3/3 | 3/3 |
| coefficient of thermal expansion, before Tg | 45 | 48 | 40 | 45 | 35 | 45 |

The components in Tables 1-2 are specifically as follows:

N740: phenol formaldehyde type novolac epoxy resin, melt viscosity (ICI/150 °C, Pa.s): 0.15;

N670: cresol type novolac epoxy resin, melt viscosity (ICI/150 °C, Pa.s): 0.2;

N865: bisphenol A type novolac epoxy resin, melt viscosity (ICI/150 °C, Pa.s): 0.25;

HP-7200H: dicyclopentadiene type novolac epoxy resin, melt viscosity (ICI/150 °C, Pa.s): 0.35;

HP-7200HH: dicyclopentadiene type novolac epoxy resin, melt viscosity (ICI/150 °C, Pa.s): 1.0;

EPPN-501: tri-functional novolac epoxy resin, melt viscosity (ICI/150 °C, Pa.s): 0.08;

BEB400: brominated epoxy resin, bromine content: 45-49%;

DER530: brominated epoxy resin, bromine content: 18-20%;

BREN-S: brominated novolac epoxy resin, bromine content: 18-20%;

BT-93W: non-reactive brominated flame retardant, bromine content: 67.2%;

MEH7500: tri-functional phenolic resin, hydroxyl equivalent weight: 96 g/eq;

TD-2090: linear phenolic resin, hydroxyl equivalent weight: 105 g/eq.

Test method for the above mentioned characteristics is as follows:

(1) The glass transition temperature (Tg): using DMA test to measure according to DMA test method provided in IPC-TM-650 2.4.24.

(2) Via filling property: take a 1.6-mm-thick copper clad laminates, drill respectively 50, 100, and 150 holes with a diameter of 0.35 mm in an area of 10*10 mm under a certain condition, then overly two sheet of prepregs (type: 2116) with the two surfaces of the copper clad laminates, and then laminate them in a press under a same condition, thereby obtaining the samples; the via filling property is measured by slice observation; if all holes are completely filled, the via filling property is "good", and if a minority of the holes are not completely filled, the via filling property is "less good". If a majority of the holes are not completely filled, the via filling property is "poor".

(3) Resistance to humidity and heat: after the copper foil on the copper clad laminate is etched, the substrate is tested; put the substrate into a pressure cooker to process for 4 hours under the condition of 120 °C and 105 KPa; then immerse it in a solder bath at 288 °C, and the corresponding time is recorded when layered delamination of the substrate emerges; when the substrate is soaking in the solder bath for more than 5 minutes and there is no phenomenon of bubbles or delamination, the test can be ended.

(4) Heat resistance: take 100*100-mm-large double-sided copper clad laminates as the samples, bake them for 2 hours at different temperatures, and then observe whether phenomenon of bubbles or delamination emerge in the samples.

(5) Thermal expansion coefficient: use TMA test to measure according to TMA test method provided in IPC-TM-650 2.4.24.1.

(6) Hydroscopic property: measure according to test method provided in IPC-TM-650 2.6.2.1.

Physical property analysis:

As shown in the physical property data of Table 1 and Table 2: in the examples 1-9, the epoxy resin is cured by phenolic resin, so the laminate materials obtained have higher glass transition temperature and excellent heat resistance; meanwhile, under the premise of keeping high glass transition temperature and heat resistance, polyfunctional epoxy resin with low melt viscosity is applied, so as to provide good via filling property during laminating multi-layer boards. The the epoxy resin with the same structure in the comparison examples 1-2 adopts phenolic resin to be cured, which can get a comparatively high glass transition temperature, but due to high viscosity and high content of fillers thereof, the via filling property is decreased; in the comparison example 3, existing phenolic resin is used for curing, and the glass transition temperature of the laminate materials obtained is low.

In summary, comparing with an ordinary copper foil substrate, the copper clad laminate of the present invention has higher glass transition temperature and via filling property, at the same time, also has good resistance to humidity and heat, which is fit for the field of high density multi-layer PCBs.

Although the present invention has been described in detail with above said embodiments, but it is not to limit the scope of the invention. So, all the modifications and changes according to the characteristic and spirit of the present invention, are involved in the protected scope of the invention.

## Claims

1. An epoxy resin composition comprising the following essential components:
(A) at least an epoxy resin, the melt viscosity thereof being not more than 0.5 Pa.s under the temperature of 150 °C;
(B) phenolic resin, the structure formula thereof being as shown in the formula 1: 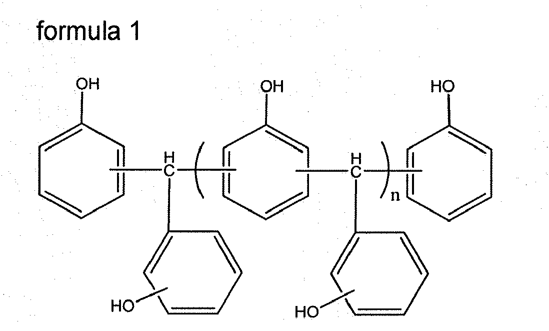 wherein, n representing an integer of 0-10.

2. The epoxy resin composition of claim 1, wherein the epoxy resin of the component (A) is mutifunctional epoxy resin with the functionality thereof being not less than 2 and epoxy equivalent weight thereof being not more than 300 g/eq.

3. The epoxy resin composition of claim 1 or 2, wherein the epoxy resin comprises cresol novolac epoxy resin, bisphenol A type novolac epoxy resin, dicyclopentadiene phenol epoxy resin, biphenyl type epoxy resin, naphthol type epoxy resin, alkylated benzene epoxy resins, tri-functional epoxy resin and tetra-functional epoxy resin, and the component (A) is at least one of the above mentioned epoxy resins, wherein the structural formula of the tri-functional epoxy resin is as shown in formula 2: 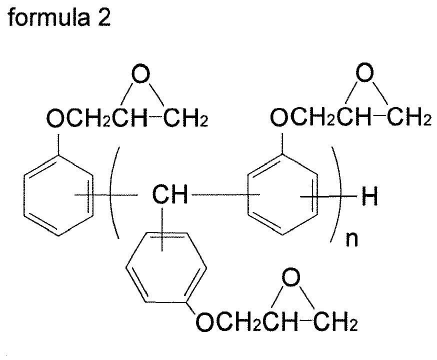 wherein n represents an integer of 1-10.

4. The epoxy resin composition of any preceding claim, wherein the epoxy resin composition also comprises flame retardant, and the flame retardant is bromine-containing flame retardant or halogen-free flame retardant; the bromine-containing flame retardant is non-reactive or reactive bromine-containing flame retardant; the reactive bromine-containing flame retardant is brominated epoxy resin, which is one or more selected from brominated bisphenol A type epoxy resin, brominated novolac type epoxy resin and brominated isocyanate modified epoxy resin; the non-reactive bromine-containing flame retardant is one or more selected from decabromodiphenyl ether, decabromobibenzyl, brominated styrene, ethylenebistetrabromophthalimide, and brominated polycarbonate.

5. The epoxy resin composition of claim 4, wherein the bromine content of the brominated epoxy resin is 15-55%; taking the total amount of the component (A) and component (B) in the epoxy resin composition as 100 parts by weight, the usage amount of the brominated epoxy resin is 10-50 parts by weight.

6. The epoxy resin composition of any preceding claim, wherein the epoxy resin composition further comprises inorganic filler or organic filler, of which the particle diameter is 0.1-10 µm; the inorganic filler is irregular or spherical inorganic filler, which is one or more selected from the group consisting of crystalline silica, fused silica, spherical silica, hollow silica, glass powder, aluminum nitride, boron nitride, silicon carbide, aluminum hydroxide, titanium dioxide, strontium titanate, barium titanate, alumina, barium sulfate, talcum powder, calcium silicate, calcium carbonate, and mica; the organic filler is one or more selected from polytetrafluoroethylene powder, polyphenylene sulfide, and poly(ether sulfones) powder.

7. The epoxy resin composition of claim 6, wherein the inorganic filler is spherical inorganic fillers after a surface treatment with surface treating agent; the surface treating agent is silane coupling agent, which is one or more selected from epoxy silane coupling agent, amino silane coupling agent and sulfur silane coupling agent.

8. The epoxy resin composition of any preceding claim, wherein the epoxy resin composition further comprises curing accelerator, which is one or more selected from imidazole compounds, derivatives of imidazole compounds, piperidine compounds, and triphenylphosphine.

9. A prepreg obtained or obtainable from the epoxy resin composition of any preceding claim, wherein the prepreg comprises a reinforcing material, and the epoxy resin composition that adheres to the reinforcing material after the reinforcing material is dipped in the epoxy resin composition and then is dried.

10. A copper clad laminate obtained or obtainable from the epoxy resin composition of any of claims 1 to 8, wherein the copper clad laminate comprises a plurality of laminated prepregs and copper foil cladded to one side or two sides of the laminated prepregs, wherein each prepreg comprises a reinforcing material, and the epoxy resin composition that adheres to the reinforcing material after the reinforcing material is dipped in the epoxy resin composition and then is dried.
